# EUROPÄISCHE PATENTSCHRIFT

(11) **EP 3 216 547 B1**
(45) Veröffentlichungstag und Bekanntmachung des Hinweises auf die Patenterteilung: **23.06.2021**
(21) Anmeldenummer: 17159757.8
(22) Anmeldetag: 08.03.2017
(51) Int. Cl.: B22F 3/105, B22F 5/04, B22F 7/06, B33Y 10/00, B23K 15/00, B33Y 80/00, B23K 15/06, B23P 15/04, B23K 26/00, B23K 26/08, B23K 26/12, B23K 26/342, C30B 29/52, C30B 13/22, C22C 14/00, C22C 27/02, C22C 30/00, C22F 1/18, F01D 5/28, C22C 1/04, B23K 103/14, B23K 101/00

(54) **VERFAHREN ZUM HERSTELLEN EINER SCHAUFEL FÜR EINE STRÖMUNGSMASCHINE**
METHOD FOR PRODUCING A ROTOR BLADE FOR A FLUID FLOW ENGINE
PROCEDE DE FABRICATION D'UNE AUBE DE TURBOMACHINE

(30) Priorität: 08.03.2016 DE 102016203785
(43) Veröffentlichungstag der Anmeldung: 13.09.2017
(73) Patentinhaber: MTU Aero Engines AG, 80995 München (DE)
(72) Erfinder: Schloffer, Martin, 81247 München (DE)

(56) Entgegenhaltungen:
- EP-A1- 2 620 594
- EP-A1- 2 772 329
- EP-A1- 2 905 350
- WO-A1-2014/172496
- WO-A1-2015/109102
- DE-A1-102012 222 745

## Beschreibung

Die Erfindung betrifft ein Verfahren zum Herstellen einer Schaufel für eine Strömungsmaschine, insbesondere für ein Flugtriebwerk. Ein weiterer Aspekt der Erfindung betrifft eine derartige Schaufel welche durch ein entsprechendes Verfahren erhältlich und/oder erhalten ist.

Bei der Fertigung von Schaufeln für Strömungsmaschinen ist zur Gewährleistung einer hohen Ausfallsicherheit größte Sorgfalt geboten. Bei der Auslegung und Herstellung der Schaufeln liegt eine erhebliche Herausforderung darin, dass diese einerseits extremen mechanischen und thermischen Belastungen Stand halten sollen und andererseits ein möglichst hoher Wirkungsgrad beim Betrieb der Strömungsmaschine erreicht werden soll.

Aus der US 2011/0135952 A1 ist ein Verfahren zum vollständigen Aufbauen eines Bauteils aus einem metallischen Pulver bekannt. Der Aufbau erfolgt auf einem Keimkristall, so dass einer Bauteilstruktur des Bauteils bei der Herstellung eine Orientierung des Keimkristalls aufgeprägt werden kann.

Die Druckschrift DE 10 2012 222 745 A1 beschreibt ein Gießverfahren, bei welchem eine einkristalline und einteilige Turbinenschaufel hergestellt wird. Die Turbinenschaufel ist dabei aus einem TiAl-Werkstoff gebildet, wobei nach dem Gießverfahren unterschiedliche Werkstoffstrukturen in verschiedenen Bereichen der Turbinenschaufel vorliegen.

Die US 2014/0154088 A1 zeigt ein schichtweises Aufbauen einer Turbinenschaufel auf einem metallischen Basismaterial. Dadurch wird der Turbinenschaufel durch ein generatives Herstellverfahren eine Maserung des metallischen Basismaterial aufgeprägt. Das mit der Turbinenschaufel verbundene Basismaterial wird als einteiliges Bauteil einer Gasturbine verwendet.

Weitere Verfahren zur Herstellung von Schaufeln sind aus den Druckschriften EP2620594A1, EP2772329A1 und WO2015109102A1 bekannt.

Aufgabe der vorliegenden Erfindung ist es, ein Verfahren der eingangs genannten Art zu schaffen, welches eine besonders aufwandsarme Fertigung von Schaufeln zulässt. Eine weitere Aufgabe der Erfindung ist es, eine Schaufel bereitzustellen, bei welcher zumindest einzelne Komponenten der Schaufel besonders einfach herstellbar sind.

Die Aufgaben werden erfindungsgemäß durch ein Verfahren mit den Merkmalen des Patentanspruchs 1 und eine Schaufel gemäß Patentanspruch 12 gelöst. Vorteilhafte Ausgestaltungen mit zweckmäßigen Weiterbildungen der Erfindung sind in den jeweiligen Unteransprüchen angegeben, wobei vorteilhafte Ausgestaltungen jedes Erfindungsaspekts als vorteilhafte Ausgestaltungen des jeweils anderen Erfindungsaspekts und umgekehrt anzusehen sind.

Ein erster Aspekt der Erfindung betrifft ein Verfahren zum Herstellen einer Schaufel für eine Strömungsmaschine, insbesondere für ein Flugtriebwerk, umfassend zumindest folgende Schritte:
- Bereitstellen eines ein- oder polykristallinen Grundkörpers mit einer Auflagefläche und generatives Aufbauen eines Schaufelblatts der Schaufel auf der Auflagefläche durch schichtweises Verschmelzen und/oder Versintern eines metallischen und/oder keramischen Pulvers aus einem ersten Werkstoff oder Werkstoffgemisch; und
- Abtrennen des Schaufelblatts von der Auflagefläche des Grundkörpers an einer Trennfläche des Schaufelblatts.

Das generative Aufbauen durch schichtweises Verschmelzen kann dabei insbesondere mit gerichteter Erstarrung erfolgen.

Das metallische und/oder keramische Pulver, welches versintert wird, kann insbesondere auch ein intermetallisches Pulver umfassen oder aus einem solchen bestehen.

Das Pulver kann insbesondere zu einem Poly- oder Singelkristall, vorzugsweise einem gerichteten Poly- oder Singelkristall, versintert werden.

Der Grundkörper kann als TiAl-Startkeimplatte, und damit beispielsweise als einkristallin oder als polykristallin ausgebildete Beta-TiAl-Kristall-Platte bereitgestellt werden. Diese Platte kann gerichtet erstarrt sein und damit eine definierte Kristallorientierung aufweisen. Bei dem generativen Aufbauen kann beispielsweise ein Elektronenstrahlschmelzen, welches auch als EBM-Verfahren (Electron Beam Melting) bezeichnet werden kann und zusätzlich oder alternativ ein selektives Laserschmelzen, welches auch als SLM-Verfahren (Selective Laser Melting) bezeichnet werden kann, eingesetzt werden. Bei dem generativen Aufbauen kann beispielsweise aus einem Pulver des ersten Werkstoffs oder Werkstoffgemisches ein Pulverbett bereitgestellt und das Schaufelblatt direkt durch Verschmelzen oder Versintern des Pulvers auf der Auflagefläche des Grundkörpers aufgebaut werden. Dabei erfolgt eine gerichtete Erstarrung einer bei dem generativen Aufbauen aus dem Pulver gebildeten, flüssigen Schmelze. Beim Erstarren der Schmelze wird dabei beispielsweise eine Orientierung der Beta-Phase des Grundkörpers einer Werkstoffstruktur des Schaufelblatts bei dessen Herstellung aufgeprägt. Auch in dem Schaufelblatt wird dadurch eine derartige Beta-Phase erzeugt. Durch das Aufprägen der Orientierung der Beta-Phase des Grundkörpers kann als Werkstoffstruktur des Schaufelblatts ein stängelkristalliner Aufbau einer Beta-Kornstruktur hergestellt werden. Die Werkstoffstruktur kann dabei entlang einer Längsachse des Schaufelblatts ausgerichtet sein. Somit können einzelne stängelartige Kristalle in dem Schaufelblatt nach dem Erstarren parallel zu der Längsachse orientiert sein. Die entsprechende Orientierung wird dabei während des generativen Aufbauens gesteuert. Nachdem das Schaufelblatt fertig aufgebaut ist, wird dieses von dem Grundkörper getrennt. Das Schaufelblatt kann dann mit einem Schaufelfuß zu der Schaufel verbunden werden. Nach dem Trennen von dem Schaufelblatt kann der Grundkörper mit der entsprechenden Auflagefläche zur Herstellung weiterer Schaufelblätter verwendet werden, wodurch insgesamt eine besonders aufwandsarme Schaufelfertigung möglich ist. Unter "generativen Aufbauen" oder "generativen Verfahren" werden gemäß der vorliegenden Erfindung alle geeigneten additiven Herstellungs- und Aufbauverfahren verstanden.

In einer vorteilhaften Ausgestaltung der Erfindung erfolgt das Abtrennen des Schaufelblatts von der Auflagefläche des Grundkörpers durch Erodieren. Dadurch ist ein besonders schonendes Trennen des Grundkörpers von dem Schaufelblatt möglich. Derselbe Grundkörper kann dadurch besonders häufig zur Herstellung weiterer Schaufelblätter verwendet werden.

In einer weiteren vorteilhaften Ausgestaltung der Erfindung erfolgt ein generatives Aufbauen eines Schaufelfußes der Schaufel auf der Trennfläche des Schaufelblatts und dabei ein Verbinden des Schaufelfußes mit dem Schaufelblatt. Das generative Aufbauen des Schaufelfußes auf der Trennfläche kann ebenfalls durch EBM und zusätzlich oder alternativ durch SLM erfolgen. Beispielsweise kann das Schaufelblatt nach dem Trennen von dem Grundkörper umgedreht und demzufolge mit nach oben gerichteter Trennfläche in einem EBM/SLM- Pulverbett aus dem ersten oder einem zweiten Werkstoff oder Werkstoffgemisch positioniert werden. Der zweite Werkstoff oder das zweite Werkstoffgemisch kann aus einer im Vergleich zu dem ersten Werkstoff oder Werkstoffgemisch duktileren γ-TiAl-Legierung gebildet sein. Nach dem Positionieren des Schaufelblatts kann das Pulverbett (beispielsweise aus dem γ-TiAl-Legierung) zudem aufgeheizt und darauf der Schaufelfuß mit einer erwünschten Struktur aufgebaut werden. Somit können auf einfache Weise unterschiedliche Strukturen im Schaufelblatt und im Schaufelfuß erzeugt werden.

In einer weiteren vorteilhaften Ausgestaltung der Erfindung wird der Schaufelfuß bei dem generativen Aufbauen durch schichtweises Verschmelzen und/oder Versintern eines metallischen und/oder keramischen Pulvers aus dem zweiten Werkstoff oder Werkstoffgemisch, welcher/welches von dem ersten Werkstoff oder Werkstoffgemisch verschieden ist, hergestellt. Dadurch in dem Schaufelfuß und in dem Schaufelblatt besonders einfach unterschiedliche Werkstoffeigenschaften eingestellt werden.

In einer weiteren vorteilhaften Ausgestaltung der Erfindung wird das generative Aufbauen des Schaufelfußes derart erzeugt, dass eine polykristalline Struktur in diesem hergestellt wird. Durch das Herstellen einer polykristallinen Struktur weist der Schaufelfuß eine besonders hohe Duktilität auf.

In einer weiteren vorteilhaften Ausgestaltung der Erfindung erfolgt das generative Aufbauen des Schaufelblatts und/oder des Schaufelfußes in einer mit einem Unterdruck beaufschlagten Aufbaukammer. Durch das Beaufschlagen der Aufbaukammer mit Unterdruck kann eine besonders effektive Verdichtung des Pulvers beim Aufbau des Schaufelblatts erfolgen und letzteres somit mit einem besonders geringen Porenanteil und entsprechend großer Stabilität hergestellt werden. Des Weiteren trägt ein geringer Luftanteil infolge der Unterdruckumgebung dazu bei, dass etwaige, unerwünschte Oxidationsprozesse des Pulvers bei dessen schichtweisem Verschmelzen und/oder Versintern durch das generative Aufbauen weniger stark ausgeprägt sind, als dies unter atmosphärischem Luftdruck und entsprechend größeren Luftanteilen im Pulver der Fall wäre.

In einer weiteren vorteilhaften Ausgestaltung der Erfindung werden der Schaufelfuß und das Schaufelblatt nach dem Verbinden einem gemeinsamen heiß-isostatischen Pressen unterzogen. Bei diesem heiß-isostatischen Pressen, welches auch als "HIP" abgekürzt werden kann, wird eine Mikrostruktur im beispielsweise aus TNM-TiAl hergestellten Schaufelfuß in eine sogenannte Triplex-Mikrostruktur mit hohem globularem Gamma-Anteil umgewandelt, wodurch beispielsweise eine gute Zerspanbarkeit des Schaufelfußes erreicht werden kann. Im Anschluss an das HIP kann eine Endbearbeitung der Schaufel, beispielsweise in Form einer Endkonturbearbeitung erfolgen.

In einer weiteren vorteilhaften Ausgestaltung der Erfindung werden der Schaufelfuß und das Schaufelblatt nach dem Verbinden einem gemeinsamen Auslagerungsglühen unterzogen. Durch das Auslagerungsglühen können netzartige Omega-Ausscheidungen in der gerichtet erstarrten Beta-Phase des Schaufelblatts erzeugt werden. Dadurch kann das Schaufelblatt besonders stabil ausgebildet werden. Durch diese Wärmebehandlung (Auslagerungsglühen) werden in dem Schaufelblatt gerichtete, netzartige Mikrostrukturen eingestellt, mittels welchen besonders hohe Anforderungen an eine Kriechfestigkeit der Schaufel erfüllt werden können.

In einer weiteren vorteilhaften Ausgestaltung der Erfindung wird als der erste Werkstoff eine TiAl-Legierung, insbesondere eine TiAl-Legierung, welche neben Ti und Al als weiteren Legierungsbestandteil wenigstens ein Element aus der Gruppe Nb, Mo, W, Zr, V, Y, Hf, Si, C und Co umfasst, bereitgestellt. Durch diese Legierungsbestandteile kann eine besonders gezielte Einstellung von Bauteileigenschaften erreicht werden. Somit sind diese Legierungen besonders geeignet um die Bauteileigenschaften beispielsweise des Schaufelblatts einzustellen.

In einer weiteren vorteilhaften Ausgestaltung der Erfindung umfasst die TiAl-Legierung 30 bis 42 at.% Al, 5 bis 25 at.% Nb, 2 bis 10 at.% Mo, 0,1 bis 10 at.% Co, 0,1 bis 0,5 at.% Si, 0,1 bis 0,5 at.% Hf und Rest Ti, insbesondere 30 bis 35 at.% Al, 15 bis 25 at.% Nb, 5 bis 10 at.% Mo, 5 bis 10 at.% Co, 0,1 bis 0,5 at.% Si, 0,1 bis 0,5 at.% Hf und Rest Ti. Eine TiAl-Legierung mit einer derartigen Zusammensetzung ist besonders für den Einsatz als Schaufelmaterial geeignet.

In einer weiteren vorteilhaften Ausgestaltung der Erfindung umfasst die TiAl-Legierung 30 bis 42 at.% Al, 5 bis 25 at.% Nb, 2 bis 10 at.% Mo, 0,1 bis 10 at.% Zr, 0,1 bis 1,5 at.% Si, 0,1 bis 0,5 at.% Hf und Rest Ti, insbesondere 32 bis 37 at.% Al, 15 bis 25 at.% Nb, 5 bis 10 at.% Mo, 1 bis 10 at.% Zr, 0,2 bis 1,0 at.% Si, 0,1 bis 0,5 at.% Hf und Rest Ti. Eine TiAl-Legierung mit einer derartigen Zusammensetzung ist ebenfalls besonders für den Einsatz als Schaufelmaterial geeignet.

Insbesondere können TiAl-Legierungen nach den in der Druckschrift EP 2 905 350 A1 beschriebenen Zusammensetzungen verwendet werden, aus welchen beispielsweise besonders stabile Schaufelblätter gebildet werden können.

In einer weiteren vorteilhaften Ausgestaltung der Erfindung wird als der zweite Werkstoff eine TiAl-Legierung, insbesondere eine γ-TiAl-Legierung, bereitgestellt. Eine derartige γ-TiAl-Legierung, welche auch als TNM-TiAl bezeichnet werden kann weist eine besonders hohe Warmfestigkeit bei gleichzeitig geringer Dichte auf. Somit ist γ-TiAl besonders für den Einsatz in Flugtriebwerken, also beispielsweise als Werkstoff für den Schaufelfuß, geeignet.

Ein zweiter Aspekt der Erfindung betrifft eine Schaufel für eine Strömungsmaschine, insbesondere für ein Flugtriebwerk, welche durch ein erfindungsgemäßes Verfahren erhältlich und/oder erhalten ist. Eine derartige Schaufel kann besonders einfach hergestellt werden. Weitere Merkmale und deren Vorteile sind den Beschreibungen des ersten Erfindungsaspekts zu entnehmen, wobei vorteilhafte Ausgestaltungen des ersten Erfindungsaspekts als vorteilhafte Ausgestaltungen des zweiten Erfindungsaspekts und umgekehrt anzusehen sind.

Weitere Merkmale der Erfindung ergeben sich aus den Ansprüchen, den Ausführungsbeispielen sowie anhand der Zeichnung. Die vorstehend in der Beschreibung genannten Merkmale und Merkmalskombinationen, sowie die nachfolgend in den Ausführungsbeispielen genannten und/oder alleine beschriebenen Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Ausführungsbeispielen nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen. Dabei zeigt:
- Fig. 1: eine schematische Perspektivansicht auf ein Schaufelblatt einer erfindungsgemäßen Schaufel, wobei das Schaufelblatt generativ auf einem Grundkörper aufgebaut wird;
- Fig. 2: eine schematische Perspektivansicht auf einen Schaufelfuß der erfindungsgemäßen Schaufel, wobei der Schaufelfuß generativ auf einer Trennfläche des Schaufelblatts aufgebaut wird; und
- Fig. 3: eine schematische Perspektivansicht auf die erfindungsgemäße Schaufel.

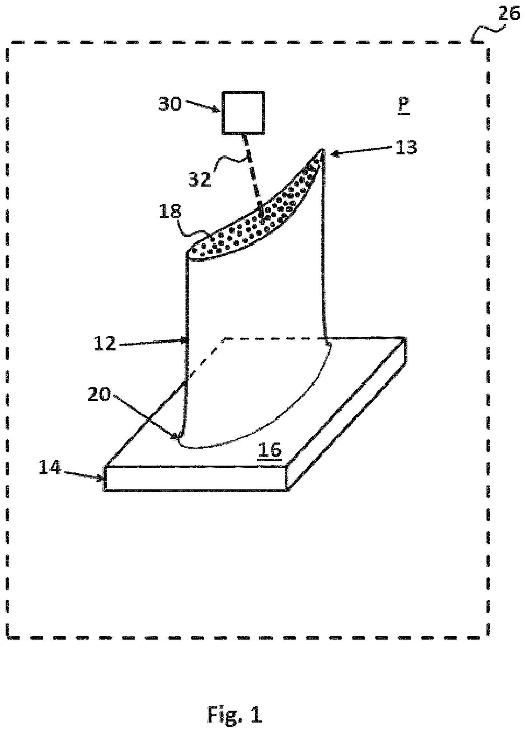

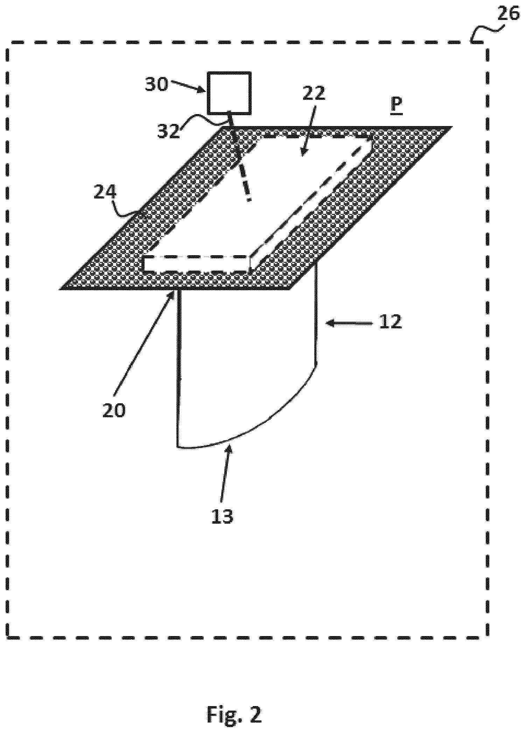

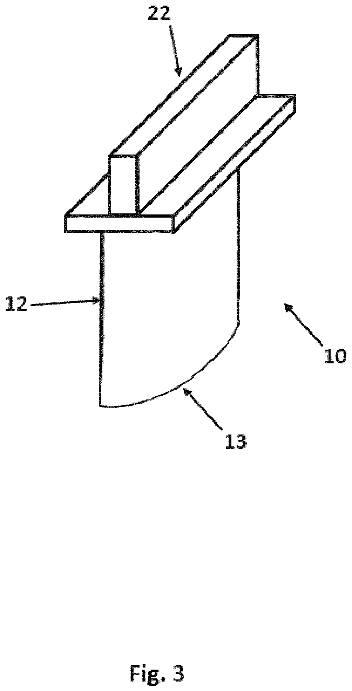

Fig. 1 und Fig. 2 zeigen einzelne Verfahrensschritte eines erfindungsgemäßen Verfahrens zur Herstellung einer Schaufel 10 für eine Strömungsmaschine. Die Schaufel 10 ist dabei vollständig in Fig. 3 gezeigt.

Fig. 1 zeigt ein generatives Aufbauen eines Schaufelblatts 12 der Schaufel 10 auf einem vorliegend polykristallinen Grundkörper 14. Alternativ oder zusätzlich kann der Grundkörper 14 auch einkristallin und/oder gerichtet erstarrt sein. Das generative Aufbauen erfolgt hierbei durch Elektronenstrahlschmelzen oder selektives Lasersintern, wobei ein als metallisches Pulver vorliegender, erster Werkstoff 18 durch einen Elektronenstrahl oder Laserstrahl 32 gesintert wird. Der Elektronen-/ Laserstrahl 32 wird durch eine Elektronenstrahlkanone oder einen Laser 30 emittiert. Das Schaufelblatt 12 wird dabei auf einer Auflagefläche 16 des Grundkörpers 14 aufgebaut. Der Grundkörper 14 ist vorliegend als Beta-TiAl-Kristall-Platte ausgebildet. Durch das generative Aufbauen des Schaufelblatts 12 auf dem ein- oder polykristallinen, vorzugsweise gerichtet erstarrten, Grundkörper 14 kann eine Orientierung einer Beta-Phase des Grundkörpers 14 einer Werkstoffstruktur des Schaufelblatts 12 bei dessen Herstellung aufgeprägt werden.

Im Anschluss an das Aufbauen des Schaufelblatts 12 erfolgt ein hier nicht dargestelltes Abtrennen des Schaufelblatts 12 von der Auflagefläche 16 des Grundkörpers 14 an einer Trennfläche 20 des Schaufelblatts 12. Das Abtrennen des Schaufelblatts 12 von der Auflagefläche 16 des Grundkörpers 14 erfolgt dabei vorzugsweise durch Erodieren. Dies stellt ein besonders schonendes Trennverfahren dar, wodurch der Grundkörper 14 zum Aufbau weiterer Schaufelblätter verwendet werden kann.

Fig. 2 zeigt einen weiteren Verfahrensschritt, in welchem ein generatives Aufbauen eines Schaufelfußes 22 der Schaufel 10 auf der Trennfläche 20 des Schaufelblatts 12 und dabei ein Verbinden des Schaufelfußes 22 mit dem Schaufelblatt 12 erfolgt. Hierzu befindet sich das Schaufelblatt 12 in einer im Vergleich zu Fig. 1 umgedrehten Lage, so dass eine Schaufelspitze 13 nunmehr in Fig. 2 in der Zeichenebene nach unten gerichtet ist. Dementsprechend ist die Trennfläche 20 nach oben gerichtet. Die Trennfläche 20 ist mit einem metallischen Pulver eines zweiten Werkstoffs 24 bedeckt. Der Schaufelfuß 22 wird durch schichtweises Versintern des Pulvers des zweiten Werkstoffs 24 mittels des Elektronenstrahls / Laserstrahls 32 aufgebaut. Die beiden Werkstoffe 18, 24 sind dabei voneinander verschieden.

Der erste Werkstoff 18 ist vorliegend als eine TiAl-Legierung ausgebildet, welche neben Ti und Al als weiteren Legierungsbestandteil Molybdän umfasst. Alternativ, können neben Ti und Al auch Niob und Molybdän als weitere Legierungsbestandteile umfasst sein. Die TiAl-Legierung kann auch andere oder mehrere Elemente aus der Gruppe Mo, W, Zr, V, Y, Hf, Si, C und Co umfassen, um etwaige Werkstoffeigenschaften des Schaufelblatts 22 möglichst exakt einzustellen. Als der zweite Werkstoff 24 wird vorliegend eine γ-TiAl-Legierung bereitgestellt.

In manchen Ausführungsformen kann die γ-TiAl-Legierung mit der Zusammensetzung TNM Ti 41-44Al 2-5Nb 0,5-2Mo 0,01-0,5B optional + 0,2-0,5Si 0,2-0,5C [at.%] bereitgestellt werden. Bei dieser Abgabe der Zusammensetzung handelt es sich um die auf dem Fachgebiet übliche Nomenklatur, bei der Ti Balance ist und den Rest von 100 at.% ausmacht oder - abgesehen von unvermeidbaren Verunreinigungen - den Rest von 100 at.% ausmacht.

Der Schaufelfuß 22 und das Schaufelblatt 12 werden nach dem Verbinden einem - hier hier nicht weiter gezeigten - gemeinsamen heiß-isostatischen Pressen sowie einem daran anschließenden gemeinsamen Auslagerungsglühen unterzogen.

Das beschriebene Verfahren wird vorliegend vollständig in einer in Fig. 1 und Fig. 2 gestrichelt dargestellten Aufbaukammer 26 durchgeführt, wobei die Aufbaukammer 26 während der Durchführung des Verfahrens mit einem Unterdruck P beaufschlagt ist. Demzufolge wird neben dem generativen Herstellen des Schaufelblatts 12 auf dem Grundkörper 14 auch das Trennen des Grundkörpers 14 von dem Schaufelblatt 12 sowie das generative Aufbauen des Schaufelfußes 22 auf dem Schaufelblatt 12 in der mit dem Unterdruck P beaufschlagen Aufbaukammer 26 durchgeführt. Dies hat den Vorteil, dass etwaige Oxidationsprozesse während der gesamten Herstellung der Schaufel zumindest weitgehend ausgeschlossen werden können. Durch den Unterdruck P können etwaige Oxidationsprozesse während des Verfahrens zumindest abgeschwächt werden.

Fig. 3 zeigt die Schaufel 10 nach deren Herstellung. Die Schaufel 10 kann nun an dem Schaufelfuß 22 beispielsweise mit einem hier nicht weiter dargestellten Rotorgrundkörper gefügt werden. Beim Fügen kann beispielsweise eine Steckverbindung zwischen dem Schaufelfuß 22 und dem Rotorgrundkörper hergestellt werden.

Dem Verfahren liegt die Erkenntnis zugrunde, dass über eine Beta-Phase erstarrende Beta-TiAl-Legierungen von deren Schmelztemperatur bis zur Raumtemperatur eine gleiche Kristallorientierung aufweisen. Dadurch kann der Grundkörpers 14 bereitgestellt werden, indem dieser durch ein Zieh- und Separationsverfahren in einem geeigneten Ofen (beispielsweise in einem Bridgman-Ofen) hergestellt wird. Hierbei kann eine gerichtete Erstarrung der Kristalle aufgrund eines gesteuerten Temperaturgradienten und Kristall-Separators erreicht werden. Dadurch kann als der Grundkörper 14 ein gerichtet erstarrter ein- oder polykristalliner Beta-TiAl-Kristall- bzw. Kristallit-Block gezüchtet werden.

### Bezugszeichenliste:

- 10: Schaufel
- 12: Schaufelblatt
- 13: Schaufelspitze
- 14: Grundkörper
- 16: Auflagefläche
- 18: erster Werkstoff
- 20: Trennfläche
- 22: Schaufelfuß
- 24: zweiter Werkstoff
- 26: Aufbaukammer
- 30: Elektronenstrahlkanone / Laser
- 32: Elektronenstrahl oder Laserstrahl

## Patentansprüche

1. Verfahren zum Herstellen einer Schaufel (10) für eine Strömungsmaschine umfassend zumindest folgende Schritte:
- Bereitstellen eines ein- oder polykristallinen Grundkörpers (14) mit einer Auflagefläche (16) und generatives Aufbauen eines Schaufelblatts (12) der Schaufel (10) auf der Auflagefläche (16) durch schichtweises Verschmelzen und/oder Versintern eines metallischen und/oder keramischen Pulvers aus einem ersten Werkstoff (18) oder Werkstoffgemisch; und
- Abtrennen des Schaufelblatts (12) von der Auflagefläche (16) des Grundkörpers (14) an einer Trennfläche (20) des Schaufelblatts (12).

2. Verfahren nach Anspruch 1, **dadurch gekennzeichnet, dass**
das Abtrennen des Schaufelblatts (12) von der Auflagefläche (16) des Grundkörpers (14) durch Erodieren erfolgt.

3. Verfahren nach Anspruch 1 oder 2,
**dadurch gekennzeichnet, dass**
ein generatives Aufbauen eines Schaufelfußes (22) der Schaufel (10) auf der Trennfläche (20) des Schaufelblatts (12) und dabei ein Verbinden des Schaufelfußes (22) mit dem Schaufelblatt (12) erfolgt.

4. Verfahren nach Anspruch 3,
**dadurch gekennzeichnet, dass**
der Schaufelfuß (22) bei dem generativen Aufbauen durch schichtweises Verschmelzen und/oder Versintern eines metallischen und/oder keramischen Pulvers aus einem zweiten Werkstoff (24) oder Werkstoffgemisch, welcher/welches von dem ersten Werkstoff (18) oder Werkstoffgemisch verschieden ist, hergestellt wird.

5. Verfahren nach Anspruch 3 oder 4,
**dadurch gekennzeichnet, dass**
das generative Aufbauen des Schaufelfußes (22) derart durchgeführt wird, dass eine polykristalline Struktur in diesem hergestellt wird.

6. Verfahren nach Anspruch einem der Ansprüche 3 bis 5,
**dadurch gekennzeichnet, dass**
das generative Aufbauen des Schaufelblatts (12) und/oder des Schaufelfußes (22) in einer mit einem Unterdruck (P) beaufschlagten Aufbaukammer (26) erfolgt.

7. Verfahren nach einem der Ansprüche 3 bis 6,
**dadurch gekennzeichnet, dass**
der Schaufelfuß (22) und das Schaufelblatt (12) nach dem Verbinden einem gemeinsamen heiß-isostatischen Pressen unterzogen werden.

8. Verfahren nach einem der Ansprüche 3 bis 7,
**dadurch gekennzeichnet, dass**
der Schaufelfuß (22) und das Schaufelblatt (12) nach dem Verbinden einem gemeinsamen Auslagerungsglühen unterzogen werden.

9. Verfahren nach einem der vorhergehenden Ansprüche,
**dadurch gekennzeichnet, dass**
als der erste Werkstoff (18) eine TiAl-Legierung, welche neben Ti und Al als weiteren Legierungsbestandteil wenigstens ein Element aus der Gruppe Nb, Mo, W, Zr, V, Y, Hf, Si, C und Co umfasst, bereitgestellt wird.

10. Verfahren nach Anspruch 9,
**dadurch gekennzeichnet, dass**
die TiAl-Legierung
- 30 bis 42 at.% Al
- 5 bis 25 at.% Nb
- 2 bis 10 at.% Mo
- 0,1 bis 10 at.% Co oder Zr
- 0,1 bis 1,5 at.% Si,
- 0,1 bis 0,5 at.% Hf und Rest Ti
- umfasst.

11. Verfahren nach einem der Ansprüche 4 bis 10,
**dadurch gekennzeichnet, dass** als der zweite Werkstoff (24) eine TiAl-Legierung bereitgestellt wird.

## Claims

1. Method for producing a blade (10) for a turbomachine, comprising at least the following steps:
- providing a monocrystalline or polycrystalline main body (14) having a support surface (16) and additively constructing an airfoil (12) of the blade (10) on the support surface (16) by fusing and/or sintering, in layers, a metal and/or ceramic powder made of a first material (18) or material mixture; and
- separating the airfoil (12) from the support surface (16) of the main body (14) at a separating surface (20) of the airfoil (12).

2. Method according claim 1, **characterized in that** the airfoil (12) is separated from the support surface (16) of the main body (14) by erosion.

3. Method according to either claim 1 or claim 2, **characterized in that** a blade root (22) of the blade (10) is additively constructed on the separating surface (20) of the airfoil (12) and the blade root (22) is thus connected to the airfoil (12).

4. Method according to claim 3, **characterized in that** during additive construction, the blade root (22) is produced by fusing and/or sintering, in layers, a metal and/or ceramic powder made of a second material (24) or material mixture which is different from the first material (18) or material mixture.

5. Method according to either claim 3 or claim 4, **characterized in that** the additive construction of the blade root (22) is carried out such that a polycrystalline structure is produced in said root.

6. Method according to any of claims 3 to 5, **characterized in that** the additive construction of the airfoil (12) and/or the blade root (22) takes place in a construction chamber (26) subjected to a negative pressure (P).

7. Method according to any of claims 3 to 6, **characterized in that** the blade root (22) and the airfoil (12) are subjected to joint hot isostatic pressing after being connected.

8. Method according to any of claims 3 to 7, **characterized in that** the blade root (22) and the airfoil (12) are subjected to joint age-annealing after being connected.

9. Method according to any of the preceding claims, **characterized in that** a TiAl alloy which, in addition to Ti and Al, comprises as a further alloy component at least one elementfrom the group Nb, Mo, W, Zr, V, Y, Hf, Si, C and Co is provided as the first material (18).

10. Method according to claim 9, **characterized in that** the TiAl alloy comprises
- 30 to 42 at.% Al
- 5 to 25 at.% Nb
- 2 to 10 at.% Mo
- 0.1 to 10 at.% Co or Zr
- 0.1 to 1.5 at.% Si,
- 0.1 to 0.5 at.% Hf and the remainder Ti.

11. Method according to any of claims 4 to 10, **characterized in that** a TiAl alloy is provided as the second material (24).

## Revendications

1. Procédé de fabrication d'une aube (10) de turbomachine comprenant au moins les étapes suivantes :
- fourniture d'un corps de base monocristallin ou polycristallin (14) doté d'une surface de support (16) et construction générative d'une pale (12) de l'aube (10) sur la surface de support (16) par fusion et/ou frittage parcouches d'une poudre métallique et/ou céramique constituée d'un premier matériau (18) ou mélange de matériaux; et
- séparation de la pale d'aube (12) de la surface de support (16) du corps de base (14) au niveau d'une surface de séparation (20) de la pale d'aube (12).

2. Procédé selon la revendication 1,
**caractérisé**
**en ce que** la pale d'aube (12) est séparée de la surface de support (16) du corps de base (14) par érosion.

3. Procédé selon la revendication 1 ou 2,
**caractérisé**
**en ce qu'**un pied d'aube (22) de l'aube (10) est construit générativement sur la surface de séparation (20) de la pale d'aube (12) et ainsi le pied d'aube (22) est assemblé avec la pale d'aube (12).

4. Procédé selon la revendication 3,
**caractérisé**
**en ce que** le pied d'aube (22) est fabriqué, lors de la construction générative, parfusion et/ou frittage par couches d'une poudre métallique et/ou céramique constituée d'un second matériau (24) ou mélange de matériaux différent du premier matériau (18) ou mélange de matériaux

5. Procédé selon la revendication 3 ou 4,
**caractérisé**
**en ce que** la construction générative du pied d'aube (22) est réalisée de sorte qu'une structure polycristalline est fabriquée en son sein.

6. Procédé selon l'une des revendications 3 à 5,
**caractérisé**
**en ce que** la construction générative de la pale d'aube (12) et/ou du pied d'aube (22) est effectuée dans une chambre de construction (26) soumise à une pression négative (P).

7. Procédé selon l'une des revendications 3 à 6,
**caractérisé**
**en ce que** le pied d'aube (22) et la pale d'aube (12) sont soumis à une compression isostatique à chaud conjointe après leurassemblage.

8. Procédé selon l'une des revendications 3 à 7,
**caractérisé**
**en ce que** le pied d'aube (22) et la pale d'aube (12) sont soumis à un recuit de vieillissement conjoint après leur assemblage.

9. Procédé selon l'une des revendications précédentes,
**caractérisé**
**en ce qu'**un alliage de TiAI qui, en plus de Ti et Al comprend, comme autre composant d'alliage, au moins un élément du groupe Nb, Mo, W, Zr, V, Y, Hf, Si, C et Co, est fourni comme premier matériau (18).

10. Procédé selon la revendication 9,
**caractérisé**
**en ce que** l'alliage de TiAI comprend
- 30 à 42 % at. d'Al,
- 5 à 25 % at. de Nb,
- 2 à 10 % at. de Mo,
- 0,1 à 10 % at. de Co ou de Zr,
- 0,1 à 1,5 % at. de Si,
- 0,1 à 0,5 % at. de Hf et le reste de Ti.

11. Procédé selon l'une des revendications 4 à 10,
**caractérisé**
**en ce qu'**un alliage de TiAI est fourni comme second matériau (24).
